# EUROPEAN PATENT APPLICATION

(11) **EP 4 848 592 A1**
(43) Date of publication of application: **02.12.2026**
(21) Application number: 26178929.1
(22) Date of filing: 15.05.2026
(51) Int. Cl.: H03M 1/06, H03M 1/16

(54) **DELAY MATCHING FOR CONTINUOUS-TIME PIPELINED ANALOG-TO-DIGITAL CONVERTERS**

(30) Priority: 30.05.2025 IN 202541052394
(71) Applicant: NXP B.V., 5656 AG Eindhoven (NL)
(72) Inventor: Singh, Kamlesh, 5656AG Eindhoven (NL); Gupta, Sushil Kumar, 5656AG Eindhoven (NL); Panpalia, Ashish Ashok, 5656AG Eindhoven (NL); Agrawal, Pankaj, 5656AG Eindhoven (NL)
(74) Representative: Schwarzweller, Thomas

(57) **Abstract**

A continuous time pipeline (CTP) analog-to-digital converter (ADC) matches a delay between signal paths of the CTP ADC based on an estimate of an analog input signal, such as an estimate based on at least one mathematical derivative of an input signal in accordance with some embodiments. The estimated of the input signal is determined along a quantization path of the CTP ADC, and is used by one or more circuits of the CTP ADC to compensate for a signal delay associated with the quantization path. By compensating for the delay based on the estimated input signal, the CTP ADC reduces or eliminates the need for tuning the ADC.

## Description

### BACKGROUND

Many different types of electronic systems employ analog-to-digital converters (ADCs) to convert analog input signals, such as received radio frequency (RF) signals, into corresponding digital signals for processing. For example, some electronic systems employ discrete-time (DT) pipelined ADCs that sample the analog input signal at one or more pipelined stages, and the pipelined stages quantize the analog signal samples to generate the digital output signal. However, DT pipelined ADCs have several limitations, such as requiring anti-aliasing filters and sample-and-hold circuits, introducing relatively high signal noise, and consuming a large amount of power. Accordingly, some electronic systems employ continuous-time pipelined (CTP) ADCs, wherein the analog input signal is processed in continuous time through different pipelined stages. The inherent anti-aliasing and other characteristics of CTP ADCs provide several advantages over DT ADCs, including lower power consumption, smaller circuit size, and other advantages. However, to achieve satisfactory performance, CTP ADCs often require relatively precise matching between different signal paths of the ADC. This in turn renders CTP ADCs sensitive to variations in manufacturing processes and operating conditions.

### BRIEF DESCRIPTION OF THE DRAWINGS

The present disclosure may be better understood, and its numerous features and advantages made apparent to those skilled in the art by referencing the accompanying drawings. The use of the same reference symbols in different drawings indicates similar or identical items.
FIG. 1 is a block diagram of a CTP ADC that matches a delay between signal paths based on an estimated derivative of an input signal in accordance with some embodiments.
FIG. 2 is a block diagram of a CTP ADC that matches a delay between signal paths by compensating for the delay at a digital-to-analog converter (DAC) in accordance with some embodiments.
FIG. 3 is a block diagram of a CTP ADC including multiple stages, wherein each stage matches a delay between signal paths based on an estimated derivative of an input signal in accordance with some embodiments.
FIG. 4 is a block diagram of a CTP ADC including an analog filter in the analog path to support relatively simpler circuitry in the quantization path in accordance with some embodiments.
FIG. 5 is a flow diagram of a method of matching a delay between signal paths of a CTP ADC based on an estimated derivative of an input signal in accordance with some embodiments.

### DETAILED DESCRIPTION

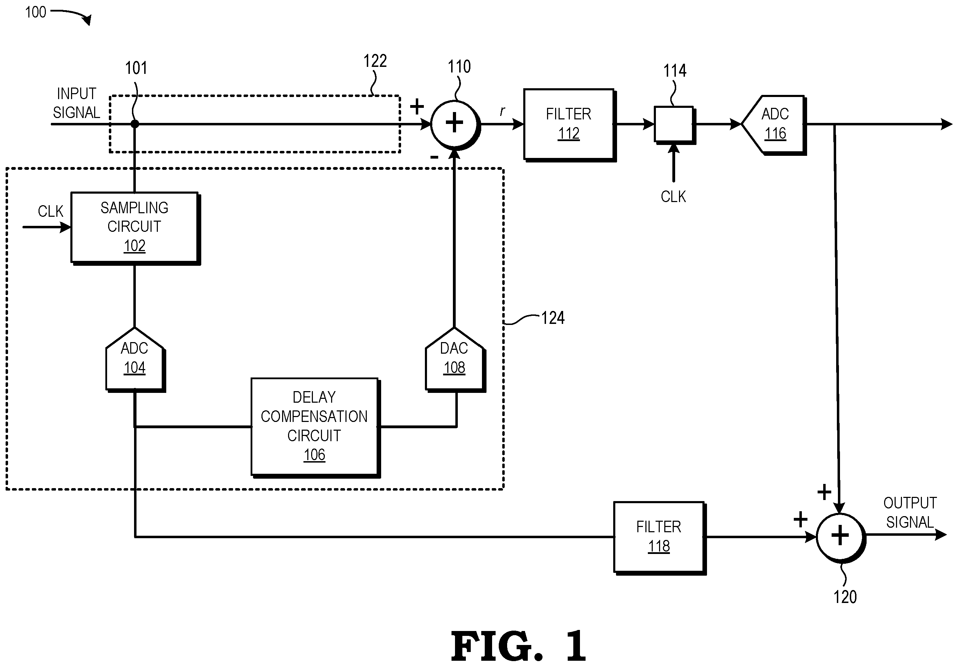

FIGs. 1-5 illustrate techniques for matching a delay between signal paths of a CTP ADC based on an estimate of an analog input signal, such as an estimate based on at least one mathematical derivative of an input signal in accordance with some embodiments. The estimated of the input signal is determined along a quantization path of the CTP ADC, and is used by one or more circuits (e.g., a filter or DAC) of the CTP ADC to compensate for a signal delay associated with the quantization path. By compensating for the delay based on the estimated input signal, the CTP ADC reduces or eliminates the need for tuning the ADC, thereby increasing the overall accuracy of the digital output and reducing the cost and time needed to manufacture and configure the ADC and its associated electronic system.

To illustrate, a CTP ADC includes one or more pipelined stages, referred to herein as residue stages. Each residue stage includes two signal paths: an analog path to provide an analog input signal and a quantization path that employs a relatively low-resolution ADC (referred to as a sub-ADC) to digitize the analog input signal and a DAC (referred to as a sub-DAC) to convert the digitized signal to the output signal of the quantization path. Each residue stage includes an adder to determine the difference, or residue, between the output signal of the analog path and the output signal of the quantization path. The residue is provided as the analog input signal for the next residue stage, and a final stage of the CTP ADC employs a digitized version of the residue output and low-resolution ADC output of the final stage to generate the final digital output signal for the CTP ADC.

To ensure accurate generation of the final digital output signal, it is desirable that the residue at each stage be generated based on matched signals in the time domain-that is, that the timing of the output signal of the analog path be matched, in time, with the output signal of the quantization path. However, the signal along the quantization path experiences a delay associated with the operation of the sub-ADC and sub-DAC in the quantization path. That is, the operation of the sub-ADC and sub-DAC delay the output signal of the quantization path relative to the analog input signal of the corresponding pipeline stage. To account for this delay, a conventional CTP ADC employs a delay element, such as a resistor-capacitor (RC) circuit, in the analog path to delay the analog input signal by a specified delay corresponding to the delay associated with the sub-ADC and sub-DAC of the quantization path. The CTP ADC thereby matches the timing of the signal along the analog path with the timing of the signal along the quantization path and thus generates a more accurate digital output signal. However, the delay elements along the different analog paths are typically sensitive to process variations (that is, to the variations in the integrated circuit or other manufacturing processes used to manufacture the CTP ADC), to temperature or other operating conditions, and the like. These variations can be ameliorated by tuning each delay element during the manufacturing process, but such tuning requires time and resources, and is often imprecise (e.g., results in relatively inaccurate delay elements).

To reduce the need for circuit tuning and improve the overall accuracy of the digital output signal, the techniques disclosed herein compensate for the delay in the quantization path of a CTP ADC by estimating the analog input signal in the digital domain. For example, in some embodiments the CTP ADC estimates the analog input signal based on a derivative of the input signal in the digital domain. In other embodiments the CTP ADC estimates the analog input signal in a combination of the digital domain and the analog domain, referred to herein as the semi-digital domain. Based on the estimate of the input signal the CTP ADC adjusts the signal along the quantization path to compensate for the delay associated with the sub-ADC and sub-DAC. The CTP ADC is thus able to compensate for the delay without employing a delay element along the analog path and thus improves the accuracy of the digital output signal and reduces the need for expensive and difficult tuning of each stage of the CTP ADC.

FIG. 1 illustrates a block diagram of a CTP ADC 100 in accordance with some embodiments. The CTP ADC 100 is generally configured to convert an analog input signal to a digital output signal. Accordingly, in different embodiments, the CTP ADC 100 is part of a subsystem, such as a receiver, of an electronic device, and converts the analog input signal to the digital output signal so that the digital output signal can be further processed by another subsystem (or another part of the same subsystem) of the electronic device. Thus, for example, in different embodiments the CTP ADC 100 is part of a wideband communication receiver (e.g., a radar receiver, wireless communication receiver (for example, a 5^{th} Generation (5G) communication receiver), a radio frequency (RF) direct sampling system, and the like. Furthermore, in different embodiments, the CTP ADC 100 is part of any one of a number of different electronic devices, such as a desktop or laptop computer, server, game console, tablet, smartphone, automotive device, and the like.

The CTP ADC 100 includes an input node 101, a sampling circuit 102, an ADC 104, a delay compensation circuit 106, a DAC 108, an adder 110, a filter 112, a sampling circuit 114, an ADC 116, a filter 118, and an adder 120. The input node 101 is a node that receives an analog input signal (e.g., a received radar signal, communication signal, RF signal, or other analog signal). The sampling circuit 102 includes an input connected to the input node 101, a clock input to receive a clock signal (designated CLK), and an output. The ADC 104 includes an input connected to the output of the sampling circuit 102 and an output. The delay compensation circuit 106 includes an input connected to the output of the ADC 104 and an output. The DAC 108 includes an input connected to the output of the ADC 104 and an output.

The adder 110 includes an input connected to the input node 101, an inverting input connected to the output of the DAC 108, and an output to generate a residue signal (designated *r*). The filter 112 includes an input connected to the output of the adder 110 to receive the residue signal r and an output. The sampling circuit 114 includes an input connected to the output of the filter 112, a clock input to receive the CLK signal, and an output. The ADC 116 includes an input connected to the output of the sampling circuit 114 and an output. The filter 118 includes an input connected to the output of the ADC 104 and an output. The adder 120 includes an input connected to the output of the filter 118 and an output to provide a digital output signal of the CTP ADC 100.

The CTP ADC 100 includes two signal paths: an input signal path 122 formed by a conductor between the input node 101 and the adder 110, and a quantization path 124 formed by the sampling circuit 102, the ADC 104, the delay compensation circuit 106, and the DAC 108. The components of the quantization path 124 is generally configured to generate an analog signal based on a quantized representation of the input signal at the input node 101. In particular, the sampling circuit 102 is a circuit, such as a switch, that samples the analog input signal at the input node 101, based on the frequency of the clock signal CLK. It will be appreciated that in some embodiments the ADC 104, the delay compensation circuit 106, and the DAC 108 all operate based on the clock signal CLK (that is, operate at the same frequency as the CLK clock signal). The ADC 104 is a relatively low-resolution ADC, such as flash ADC, that generates a quantized signal based on the samples provided by the sampling circuit 102. ADCs that generate quantized signals in a quantization path of a CTP ADC are sometimes referred to herein as sub-ADCs.

The delay compensation circuit 106 is generally configured to adjust the quantized signal provided by the sub-ADC 104, in order to account for the signal delay associated with the quantization path 124. The operations of the delay compensation circuit 106 is described further below.

The DAC 108 in the quantization path 124 is a DAC, such as a resistive DAC, that generates an analog output signal based on a quantized input signal. DACs that generate analog signals based on quantized signals in a quantization path of a CTP ADC are sometimes referred to herein as sub-DACs. The adder 110 is configured to invert the output signal of the sub-DAC 108, and to add the inverted signal to the analog input signal, thus effectively subtracting the output signal of the DAC 108 from the input signal, to generate the residue signal *r.*

The filter 112 is an analog filter generally configured to filter the residue signal *r* to, for example remove noise, to amplify the residue signal, to otherwise condition the residue signal based on specified conditioning parameters, or any combination thereof. For example, in some embodiments the filter 112 is a fourth order Butterworth filter that implements the following transfer function: ${G}_{112} \left(s\right) = \frac{4}{1 + 1.848 \frac{s}{2 {πf}_{c}} + {\left(\frac{s}{2 {πf}_{c}}\right)}^{2}}$ where *s* is a complex variable to represent the Laplace domain transfer function G(s) and f_{c} is the filter cutoff frequency.

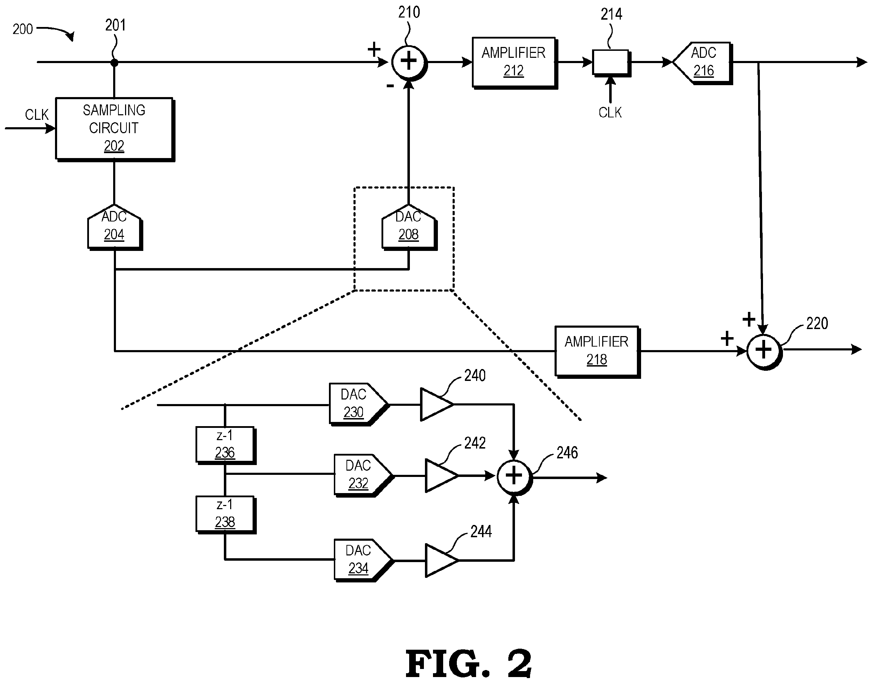

The sampling circuit 114 and the ADC 116 are similar circuits as the sampling circuit 102 and ADC 104, respectively, and together perform similar operations to quantize the output of the filter 112. Thus, the output signal of the ADC 116 is a filtered and quantized representation of the residue signal r. The filter 118 is a digital filter configured to perform a similar operation as the filter 112, but in the digital domain. That is, the filter 118 implements a similar transfer function as the filter 112, but in the digital domain. Thus, the output of the filter 118 is a filtered representation of the quantized signal generated by the sub-ADC 104. The adder 120 is configured to add the filtered signals provided by the filter 118 and the ADC 116 to generate the digital output signal of the CTP ADC 100. In particular, the adder 120 combines the relatively coarse digital signal generated based on the output of the ADC 104 with the finer resolution of the digital signal based on the residue *r* and thus produces a digital output signal that represents the analog input signal. As described further below with respect to FIG. 2, in some embodiments the CTP ADC 100 includes additional pipeline stages to produce a set of successive residue values, with each additional residue value providing finer resolution for the digital output signal.

Returning to the quantization path 124 and the adder 110, as noted above the adder 110 is configured to subtract the signal provided by the quantization path 124 from the analog input signal in order to generate the residue *r.* For accurate generation of the digital output signal, the residue *r* is specified to represent the difference between the analog input signal and the quantized signal generated by the ADC 104 at the same point in time. However, the operation of the components of the quantization path 124 (e.g., the ADC 104 and the DAC 108) introduce a delay in the quantization signal relative to the analog input signal. If this delay is not addressed, the residue signal r would provide a relatively inaccurate representation of the difference between the analog input signal and the quantized signal at the adder 110, leading to inaccuracies in the digital output signal and overall poor performance of the CTP ADC 100.

Accordingly, the delay compensation circuit 106 is a circuit, such as a predictive digital filter, configured to modify the output signal of the ADC 104 to account for the delay along the signal path. The delay compensation circuit 106 accounts for the delay by identifying a derivative (e.g., a first-order derivative) of the output signal and adjusting the output signal based on the identified derivative.

To illustrate, an estimate of the delay in the analog input signal can be expressed as follows: $x \left(t-{t}_{d}\right) \approx x \left(t\right) - x ′ \left(t\right) {t}_{d}$ where *x*(*t*) is the input signal *x*'(*t*) is the first order derivative of x(t), and *t_{d}* is the delay associated with the quantization path 124 (that is, the signal delay resulting from operations of the ADC 104, the compensation circuit 106, and the DAC 108). Accordingly, in some embodiments the delay compensation circuit 106 is configured to estimate, in the digital domain, the derivative *x*'(*t*) and adjust the output signal of the ADC 104 to compensate for the delay *t_{d}.*

For example, in some embodiments the delay compensation circuit 106 is a predictive digital filter than implements a backward differential function. Thus, in some embodiments, the delay compensation circuit 106 determines the derivative based on the following function: ${F}_{d} \left(z\right) = \frac{1 - {z}^{- 1}}{{T}_{CLK}}$ where z is the current sample of the input signal to the delay compensation circuit 106, z⁻¹ is the previous sample of the input signal, and T_{CLK} is the period of the clock signal CLK.

In other embodiments, the delay compensation circuit 106 implements a different backward differential function, such as a backward differential function based on more samples of the input signal. For example, in some embodiments the delay compensation circuit 106 identifies the derivative based on the following function: ${F}_{d} \left(z\right) = \frac{3 - 4 {z}^{- 1} + {z}^{- 2}}{2 {T}_{CLK}}$ where z⁻² is the sample prior to the z⁻¹ sample.

The derivative *x*'(*t*) is the result of multiplying F_{d}(z) by t_{d}. In some embodiments, the delay the delay t_{d} is expected to be the same or approximately the same as the period T_{CLK} and therefore the multiplication cancels out the T_{CLK} term in the denominator of the above functions. Accordingly, in some embodiments the delay compensation circuit 106 is a digital filter that implements a transfer function based on the following function: $F \left(z\right) = 1 - {z}^{- 1}$ while in other embodiments the delay compensation circuit 106 is a digital filter that implements a transfer function based on the following function: $F \left(z\right) = \frac{2 - 4 {z}^{- 1} + {z}^{- 2}}{2}$

Thus, in some embodiments, the digital compensation circuit 106 is a digital filter that implements the following transfer function: ${F}_{c} \left(z\right) = 1 + F \left(z\right)$

The digital compensation circuit 106 thus modifies the output signal of the ADC 104 to account for the delay t_{d} and thus matches the signal provided by the quantization path 124 to the adder 110 with the analog input signal. This in turn ensures that the adder 110 provides an accurate residue value, and thus that the digital output signal of the CTP ADC 100 is accurate. Furthermore, the analog input path 122 does not include a delay element, such as an RC circuit, in the path, thus obviating the need for circuit tuning while maintaining accuracy of the digital output signal.

It will be appreciated that the above description of the digital compensation circuit 106 is an example only, and that in other embodiments the digital compensation circuit 106 is a predictive digital filter having a different architecture. In addition, in some embodiments an analog filter (e.g., a resistor-capacitor filter, inductor-capacitor filter, or active filter) is placed between the input node 101 and the adder 110. This allows for the delay compensation circuit 106 to have reduced complexity, such as by implementing a predictive digital filter of lower complexity than described above.

In some embodiments, rather than a separate digital compensation circuit such as the digital compensation circuit 106, a CTP ADC compensates for signal delay at the DAC in the quantization path, using both the digital domain and the analog domain (referred to collectively as the semi-digital domain). An example is illustrated at FIG. 2 in accordance with some embodiments. In particular, FIG. 2 illustrates a CTP ADC 200, including an input node 201, a sampling circuit 202, an ADC 204, a DAC 208, an adder 210, a filter 212, a sampling circuit 214, an ADC 216, a filter 218, and an adder 220. These components are connected similarly to the corresponding components of FIG. 1 (e.g., the input node 201 is connected similarly to the input node 101 of FIG. 1). However, in the embodiment of FIG. 2, the output of the ADC 204 is connected directly to the input of the DAC 208. That is, there is not a delay compensation circuit between the ADC 204 and the DAC 208. Instead, the DAC 208 is configured to adjust the digital signal received from the ADC 204 based on the delay t_{d}, and to implement the adjustment as part of the digital to analog conversion process.

To illustrate, in the embodiment of FIG. 2 the DAC 208 includes a plurality of DAC elements, designated DAC elements 230, 232, and 234, wherein each DAC element is configured to convert a received digital sample to a corresponding analog value. The DAC 208 further includes storage elements 236 and 238 connected to DAC elements 232 and 234, respectively. The storage element 236 stores the previous sample, relative to the sample provided to the DAC element 230. The storage element 236 stores the previous sample relative to the same stored at the storage element 236. Thus, DAC element 230 receives the current sample z, the DAC element 232 receives the sample z⁻¹, and the DAC element 234 receives the sample z⁻².

The DAC 208 further includes a plurality of multipliers 240, 242, and 244, connected to the outputs of DAC elements 230, DAC element 232, and DAC elements 234, respectively. Each of the multipliers 240, 242, and 244 is an analog multiplier configured to multiply the output of the corresponding DAC by a specified factor, wherein in some embodiments the factor is different between the different multipliers. The DAC 208 also includes an adder 246 to add the outputs of the multipliers 240, 242, and 244 to generate the analog output signal of the DAC 208. The multiplication factors for the multipliers 240, 242, and 244 are set (e.g., during the design and manufacturing of the CTP ADC 200) so that the DAC 208 implements a transfer function F_{c}(z), such as the transfer function F_{c}(z) set forth above. The DAC 208 thus estimates the analog input signal by determining the derivative of the analog input signal and adjusts the received digital signal based on this estimate, thereby compensating for the delay associated with the quantization path. In some embodiments, as with FIG. 1 above, an analog filter (e.g., a resistor-capacitor filter, inductor-capacitor filter, or active filter) is placed between the input node 201 and the adder 210. This allows for the delay compensation aspects of the DAC 208 to have reduced complexity.

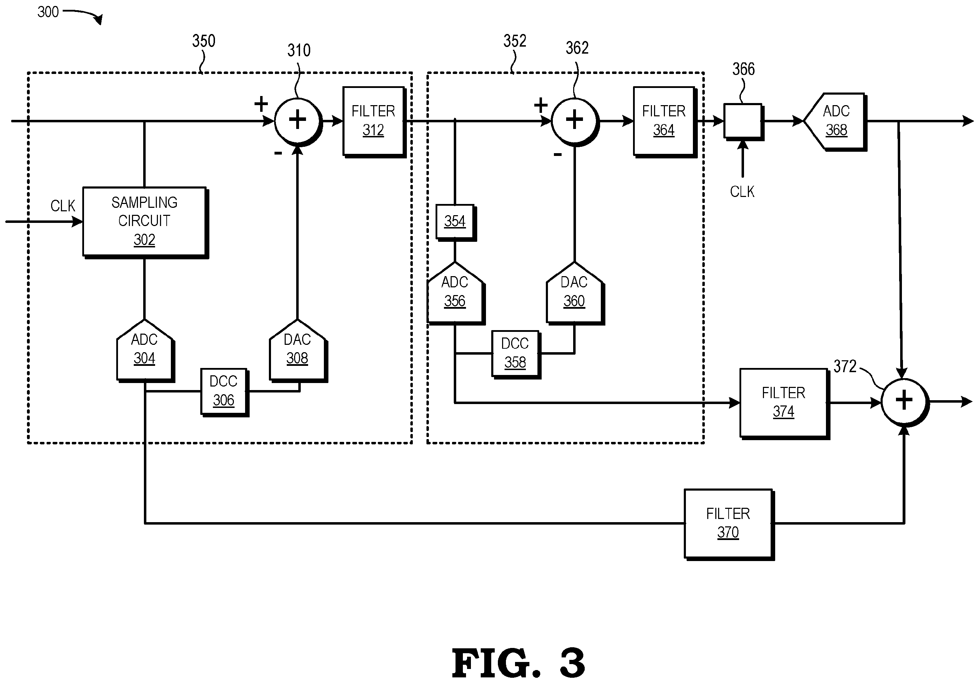

In some embodiments, a CTP ADC includes multiple pipeline stages, with each stage generating a residue value based on signals from an input signal path and a quantization path of the stage. The quantization path of each stage determines an estimate for the corresponding input signal and adjusts the quantization path signal based on the estimated input signal to account for the delay along the quantization path. An example is illustrated at FIG. 3 in accordance with some embodiments. FIG. 3 illustrates a CTP ADC 300 including two pipeline residue stages, designated residue stage 350 and residue stage 352.

The residue stage 350 includes an input to receive an analog input signal, a digital output to provide a coarse digitized signal based on the analog input signal, and an output to provide an analog signal (referred to as a first residue signal) representing a first residue value. The first residue signal is an intermediate analog signal, in that it is a signal provided to another pipeline stage of the CTP ADC 300. The residue stage 352 includes an input to receive the first residue signal, an output to provide a coarse digitized signal based on the first residue signal, and an output to provide an analog signal (referred to a second residue signal) representing a second residue value.

The CTP ADC 300 further includes a sampling circuit 366 to receive the second residue signal, an ADC 368 connected to the output of the sampling circuit 366. The ADC 368 converts the sampled second residue signal to a digital signal. The CTP ADC 300 includes filters 370 and 374 to filter the digital outputs of the residue stages 350 and 352 respectively. The filter operations are discussed further below. The CTP ADC 300 includes an adder 372 that receives the digital second residue signal (provided by the ADC 368), the output of the filter 374, and the output of the filter 370. The adder combines the received signals to generate the digital output signal for the CTP ADC 300.

Each of the residue stages 350 and 352 includes an analog input signal path and a quantization path similar to that described above with the CTP ADC 100 of FIG. 1. Thus, the residue stage 350 includes an input node to receive the analog input signal, a sampling circuit 302, an ADC 304, a delay compensation circuit 306, a DAC 308, an adder 310, and a filter 312. The sampling circuit 302 includes an input connected to the input node, a clock input to receive a clock signal (designated CLK), and an output. The ADC 304 includes an input connected to the output of the sampling circuit 302 and an output to provide the coarse digitized input signal to the filter 370. The delay compensation circuit 306 includes an input connected to the output of the ADC 304 and an output. The DAC 308 includes an input connected to the output of the ADC 304 and an output. The adder 310 includes an input connected to the input node, an inverting input connected to the output of the DAC 308, and an output to generate a residue signal. The filter 312 includes an input connected to the output of the adder 310 to receive the residue signal and an output to provide the first residue signal.

The residue stage 352 includes an input node to receive the first residue signal as an input signal, a sampling circuit 354, an ADC 356, a delay compensation circuit 358, a DAC 360, an adder 362, and a filter 364. The sampling circuit 354 includes an input connected to the input node, a clock input to receive a clock signal (designated CLK), and an output. The ADC 356 includes an input connected to the output of the sampling circuit 354 and an output to provide the coarse digitized input signal to the filter 374. The delay compensation circuit 358 includes an input connected to the output of the ADC 356 and an output. The DAC 360 includes an input connected to the output of the ADC 356 and an output. The adder 362 includes an input connected to the input node, an inverting input connected to the output of the DAC 360, and an output to generate a residue signal. The filter 364 includes an input connected to the output of the adder 362 to receive the residue signal and an output to provide the second residue signal.

The residue stages 350 and 352 each operate similarly to the corresponding portion of CTP ADC 100 of FIG. 1. In particular, each of the residue stages 350 and 352 includes an input signal path, a quantization path to coarsely digitize the corresponding input signal (at the ADCs 304 and 356, respectively), adjust the digitized signal based on the delay associated with the respective quantization path (at the digital compensation circuits 306 and 358, respectively), and convert the adjusted signal to an analog signal for provision to the corresponding adder (at the DACs 308 and 360, respectively). Thus, each of the digital compensation circuits 306 and 358 is configured to determine an estimate for the corresponding input signal, wherein the estimate is based on a derivative of the input signal. Based on the determined derivative, the digital compensation circuits 306 and 358 modify the quantization path signal to match the delay of the signal with the corresponding analog input signal. Thus, in the embodiment of FIG. 1, each residue stage compensates for the delay associated with the corresponding quantization path. The CTP ADC 100 thereby maintains or improves the accuracy of the digital output signal without requiring extensive tuning of each residue stage.

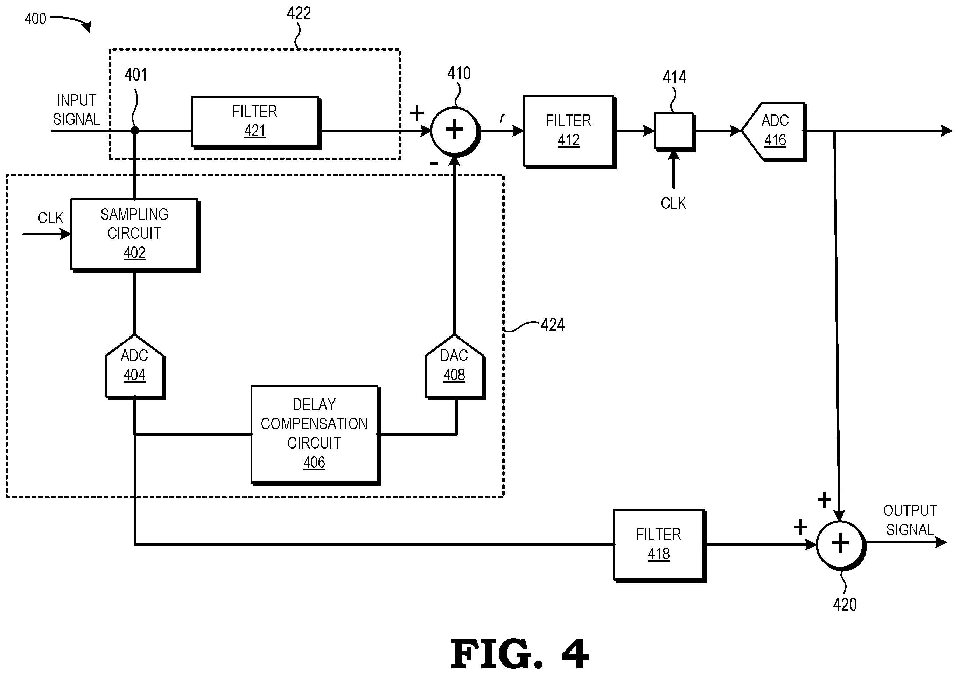

In some embodiments, a CTP ADC includes an analog filter in the analog path, thereby providing some delay along the analog path. This delay allows for the compensation circuitry along the quantization path (e.g., the digital filter or compensation circuitry in the DAC of the quantization path) to be implemented with relatively simpler circuitry, such as with a less complex digital filter or a DAC with fewer delay elements and analog multipliers. An example is illustrated at FIG. 4 in accordance with some embodiments. In particular, FIG. 4 illustrates a CTP ADC 400 including an input node 401, a sampling circuit 402, an ADC 404, a delay compensation circuit 406, a DAC 408, an adder 410, a filter 412, a sampling circuit 414, an ADC 416, a filter 418, an adder 420, and an analog filter 421. The input node 401 is a node that receives an analog input signal (e.g., a received radar signal, communication signal, RF signal, or other analog signal). The sampling circuit 402 includes an input connected to the input node 401, a clock input to receive a clock signal (designated CLK), and an output. The ADC 404 includes an input connected to the output of the sampling circuit 402 and an output. The delay compensation circuit 406 includes an input connected to the output of the ADC 404 and an output. The DAC 408 includes an input connected to the output of the ADC 404 and an output.

The analog filter 421 includes an input connected to the input node 401 and an output. The adder 410 includes an input connected to the output of the analog filter 421, an inverting input connected to the output of the DAC 408, and an output to generate a residue signal (designated r). The filter 412 includes an input connected to the output of the adder 410 to receive the residue signal r and an output. The sampling circuit 414 includes an input connected to the output of the filter 412, a clock input to receive the CLK signal, and an output. The ADC 416 includes an input connected to the output of the sampling circuit 414 and an output. The filter 418 includes an input connected to the output of the ADC 104 and an output. The adder 420 includes an input connected to the output of the filter 418 and an output to provide a digital output signal of the CTP ADC 400.

Similar to the CTP ADC 100 of FIG. 1, the CTP ADC 400 includes two signal paths: an input signal path 422 and a quantization path 424. However, in contrast to the input signal path 122 of FIG. 1, the input signal path 422 includes the analog filter 421. The analog filter 421 is an RC filter, an LC filter, an active filter, or other analog filter configured to delay the analog input signal provided by the input node 401. The delay provided by the analog filter 421 is within a specified range, but in some embodiments is not tuned to a specific delay or is coarsely tuned to the specified range. The delay provided by the analog filter 421 allows for the delay compensation circuit 406 to be relatively simplified, as compared to the delay compensation circuit 106. For example, in some embodiments the delay compensation circuit is a digital filter that implements a relatively simple difference function. Thus, the embodiment of FIG. 4 allows for compensation for the delay along the quantization path, in the digital or semi-digital domain, with a relatively simple filter, DAC, or other circuit, but without requiring extensive tuning of the analog filter 421.

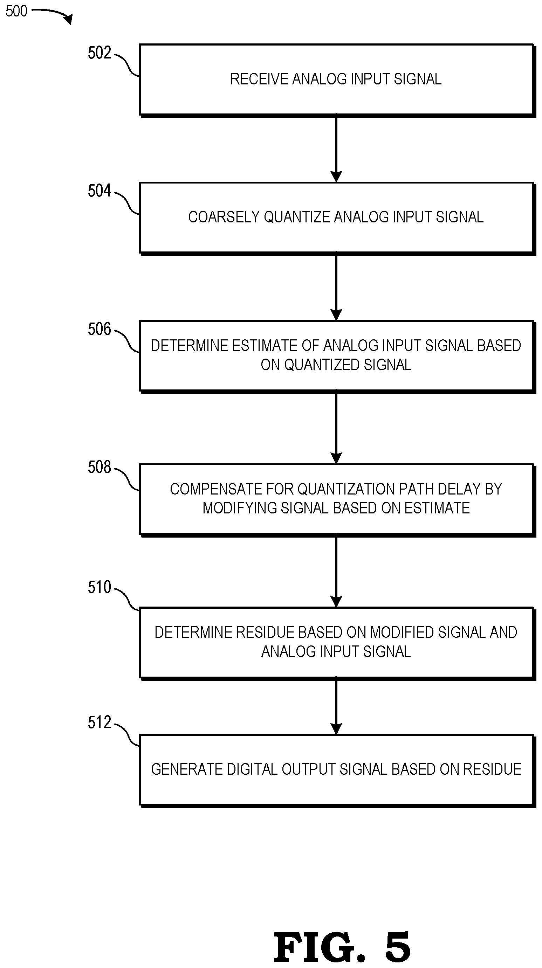

FIG. 5 illustrates a flow diagram of a method 500 of converting an analog signal to a digital signal at a CTP ADC in accordance with some embodiments. For purposes of description, the method 500 is described with respect to an example implementation at the CTP ADC 100 of FIG. 1, but it will be appreciated that in other embodiments the method 500 is implemented at an ADC having a different configuration. At block 502, the CTP ADC receives the analog input signal at the input node 101. In response, at block 504 the ADC 104 coarsely quantizes the analog input signal to generate a quantized signal. That is, the ADC 104 digitizes the analog input signal at a relatively low resolution (e.g., 3 bits or less).

At block 506, an estimate of the analog input signal is determined along the quantization path. For example, in some embodiments, the delay compensation circuit 106 implements a backwards differential function in the digital domain to identify a derivative of the input signal. In other embodiments, the derivative is determined at the DAC of the quantization path (e.g., DAC 208 of FIG. 2) in the course of converting the coarsely quantized signal to an analog signal.

At block 508, the quantization signal (that is, the signal along the quantization path) is modified based on the estimated input signal, thereby compensating for the signal delay imposed by the components along the quantization path (e.g., the ADC 104 and DAC 108). For example, in some embodiments the delay compensation circuit 106 implements a digital filter that modifies the quantization signal based on the derivative as described above. In other embodiments, the DAC of the quantization path modifies the quantization signal based on the derivative, in the course of converting the quantization signal to an analog signal.

At block 510, the adder 110 generates the residue r by subtracting the modified quantization signal from the analog input signal. Because the quantization signal has been modified based on the estimated input signal, the quantization signal is matched, in time, with the analog input signal, as if both signals had experienced a similar delay along their respective paths to the adder 110. At block 512, the CTP ADC 100 generates the digital output signal based on the residue. For example, in some implementations the CTP ADC 100 generates the digital output signal by digitizing the residue, filtering both the digitized residue and the coarse quantized signal generated by the ADC 104, and combining (e.g., adding) the filtered signals.

In some embodiments, certain aspects of the techniques described above may implemented by one or more processors of a processing system executing software. The software comprises one or more sets of executable instructions stored or otherwise tangibly embodied on a non-transitory computer readable storage medium. The software can include the instructions and certain data that, when executed by the one or more processors, manipulate the one or more processors to perform one or more aspects of the techniques described above. The non-transitory computer readable storage medium can include, for example, a magnetic or optical disk storage device, solid state storage devices such as Flash memory, a cache, random access memory (RAM) or other non-volatile memory device or devices, and the like. The executable instructions stored on the non-transitory computer readable storage medium may be in source code, assembly language code, object code, or other instruction format that is interpreted or otherwise executable by one or more processors.

The present disclosure extends to a continuous-time pipeline (CTP) analog-to-digital converter (ADC), comprising: a plurality of pipeline stages, each of the plurality of pipeline stages comprising: an ADC to generate a digitized signal based an analog input signal of the pipeline stage;a compensation circuit to:estimate the analog input signal; and compensate the digitized signal for a delay associated with digitizing the analog input signal, the compensating based on the estimated analog input signal; a first adder to determine a first residue value based on the analog input signal and the compensated first digitized signal; and a second adder to generate a digital output signal for the CTP ADC based on the first residue value.

In one or more embodiments, the compensation circuit estimates the analog input signal in one of a digital domain and a semi-digital domain. In one or more such embodiments, the compensation circuit comprises a digital filter. In one or more such embodiments, the digital filter implements a backwards differential function. In one or more embodiments, the backwards differential function employs at least two samples of the analog input signal.

A computer readable storage medium may include any storage medium, or combination of storage media, accessible by a computer system during use to provide instructions and/or data to the computer system. Such storage media can include, but is not limited to, optical media (e.g., compact disc (CD), digital versatile disc (DVD), Blu-Ray disc), magnetic media (e.g., floppy disc , magnetic tape, or magnetic hard drive), volatile memory (e.g., random access memory (RAM) or cache), non-volatile memory (e.g., read-only memory (ROM) or Flash memory), or microelectromechanical systems (MEMS)-based storage media. The computer readable storage medium may be embedded in the computing system (e.g., system RAM or ROM), fixedly attached to the computing system (e.g., a magnetic hard drive), removably attached to the computing system (e.g., an optical disc or Universal Serial Bus (USB)-based Flash memory), or coupled to the computer system via a wired or wireless network (e.g., network accessible storage (NAS)).

Note that not all of the activities or elements described above in the general description are required, that a portion of a specific activity or device may not be required, and that one or more further activities may be performed, or elements included, in addition to those described. Still further, the order in which activities are listed are not necessarily the order in which they are performed. Also, the concepts have been described with reference to specific embodiments. However, one of ordinary skill in the art appreciates that various modifications and changes can be made without departing from the scope of the present disclosure as set forth in the claims below. Accordingly, the specification and figures are to be regarded in an illustrative rather than a restrictive sense, and all such modifications are intended to be included within the scope of the present disclosure.

Benefits, other advantages, and solutions to problems have been described above with regard to specific embodiments. However, the benefits, advantages, solutions to problems, and any feature(s) that may cause any benefit, advantage, or solution to occur or become more pronounced are not to be construed as a critical, required, or essential feature of any or all the claims. Moreover, the particular embodiments disclosed above are illustrative only, as the disclosed subject matter may be modified and practiced in different but equivalent manners apparent to those skilled in the art having the benefit of the teachings herein. No limitations are intended to the details of construction or design herein shown, other than as described in the claims below. It is therefore evident that the particular embodiments disclosed above may be altered or modified and all such variations are considered within the scope of the disclosed subject matter. Accordingly, the protection sought herein is as set forth in the claims below.

## Claims

1. A method comprising:
digitizing an analog input signal at a continuous-time pipelined, CTP, analog-to-digital converter, ADC, to generate a first digitized signal, wherein digitizing comprises:
estimating the analog input signal; and
compensating the first digitized signal for a first delay associated with digitizing the analog input signal, the compensating based on the estimated analog input signal;
determining a first residue value based on the analog input signal and the compensated first digitized signal; and
generating a digital output signal for the CTP ADC based on the first residue value.

2. The method of claim 1, wherein estimating the analog input signal comprises estimating the analog input signal in one of a digital domain and a semi-digital domain.

3. The method of claim 2, wherein estimating the analog input signal comprises estimating a derivative of the analog input signal at a digital filter of the CTP ADC.

4. The method of claim 3, wherein the digital filter implements a backwards differential function.

5. The method of claim 4, wherein the backwards differential function employs at least two samples of the analog input signal.

6. The method of any preceding claim 1, further comprising compensating the first digitized signal at a digital-to-analog converter, DAC, of the CTP ADC.

7. The method of any preceding claim, further comprising:
generating an intermediate analog signal based on the first residue value;
digitizing the intermediate analog signal to generate a second digitized signal, wherein digitizing comprises:
estimating the intermediate analog signal; and
compensating the second digitized signal for a second delay associated with digitizing the analog input signal, the compensating based on the estimated intermediate analog signal;
determining a second residue value based on the intermediate analog signal and the compensated second digitized signal; and
generating the digital output signal for the CTP ADC based on the second residue value.

8. A continuous-time pipeline, CTP, analog-to-digital converter, ADC:
a first ADC to generate a first digitized signal based an analog input signal;
a first compensation circuit to:
estimate the analog input signal; and
compensate the first digitized signal for a first delay associated with digitizing the analog input signal, the compensating based on the estimated analog input signal;
a first adder to determine a first residue value based on the analog input signal and the compensated first digitized signal; and
a second adder to generate a digital output signal for the CTP ADC based on the first residue value.

9. The CTP ADC of claim 8, wherein the first compensation circuit estimates the analog input signal in one of a digital domain and a semi-digital domain.

10. The CTP ADC of claim 9, wherein the first compensation circuit comprises a digital filter.

11. The CTP ADC of claim 10, wherein the digital filter implements a backwards differential function.

12. The CTP ADC of claim 11, wherein the backwards differential function employs at least two samples of the analog input signal.

13. The CTP ADC of any of claims 8 to 12, wherein the first compensation circuit comprises a digital-to-analog converter, DAC.

14. The CTP ADC of any of claims 8 to 13, further comprising an analog filter including an input to receive the analog input signal and an output coupled to an input of the first adder.

15. The CTP ADC of any of claims 8 ot 14, further comprising:
a second ADC to generate a second digitized signal an intermediate analog signal, the intermediate analog signal based on the first residue value;
a second compensation circuit to:
estimate the intermediate analog signal; and
compensate the second digitized signal for a second delay associated with digitizing the intermediate analog signal, the compensating based on the estimated intermediate analog signal;
a third adder to determine a second residue value based on the intermediate analog signal and the compensated second digitized signal; and
wherein the second adder generates the digital output signal for the CTP ADC based on the second residue value.
